# FASCICULE DE BREVET EUROPEEN

(11) **EP 3 552 237 B1**
(45) Date de publication et mention de la délivrance du brevet: **22.01.2025**
(21) Numéro de dépôt: 17816992.6
(22) Date de dépôt: 05.12.2017
(51) Int. Cl.: H01L 27/146

(54) **DISPOSITIF DE DÉTECTION MULTISPECTRALE AMÉLIORÉE**
VORRICHTUNG ZUR VERBESSERTEN MULTISPEKTRALEN ERKENNUNG
DEVICE FOR IMPROVED MULTISPECTRAL DETECTION

(30) Priorité: 07.12.2016 FR 1662090
(43) Date de publication de la demande: 16.10.2019
(73) Titulaire: LYNRED, 91120 Palaiseau (FR)
(72) Inventeur: PERE LAPERNE, Nicolas, 38000 Grenoble (FR); JENOUVRIER, Pierre, 38080 L'Isle d'Abeau (FR); REIBEL, Yann, 38113 Veurey-Voroise (FR)
(74) Mandataire: Talbot, Alexandre
(86) Numéro de dépôt international: PCT/FR2017/053405
(87) Numéro de publication internationale: WO 2018/104655

(56) Documents cités:
- EP-A1- 0 757 234
- EP-A1- 2 117 047
- EP-A1- 2 827 375
- EP-A2- 2 442 555
- EP-A2- 3 133 646
- US-A1- 2005 189 492
- US-A1- 2013 188 057
- US-A1- 2016 080 669
- K S WANJALA ET AL: "Optical and Electrical Characterization of CuO Thin Films as Absorber Material for Solar Cell Applications", AMERICAN JOURNAL OF CONDENSED MATTER PHYSICS, 1 January 2016 (2016-01-01), pages 1 - 6, XP055407556, Retrieved from the Internet <URL:http://article.sapub.org/10.5923.j.ajcmp.20160601.01.html#Sec1> [retrieved on 20170919], DOI: 10.5923/j.ajcmp.20160601.01

## Description

### Domaine technique de l'invention

L'invention est relative à un dispositif de détection multispectrale.

L'invention est également relative à un procédé de fabrication d'un dispositif de détection multispectrale.

### État de la technique

Dans le domaine des dispositifs de détection, afin de capter un maximum d'information sur une scène en cours d'observation, il est avantageux d'utiliser plusieurs bandes spectrales différentes.

Plusieurs détecteurs sont utilisés et ils sont associés à des bandes spectrales différentes. De cette manière, chaque détecteur vient capter une information spécifique de la scène observée ce qui permet de faciliter l'analyse en croisant les différentes données.

Une manière simple de réaliser un dispositif de détection est d'associer plusieurs photodétecteurs différents qui sont configurés pour détecter une bande spectrale spécifique. Chaque photodétecteur est associé à un circuit de lecture qui va stocker les charges électriques représentatives de l'information reçue.

L'information électrique générée est ensuite envoyée à un circuit de traitement qui analyse les différentes données pour fournir une information exploitable par l'utilisateur.

De manière classique, le dispositif de détection comporte des premiers photodétecteurs qui sont réalisés selon une première architecture et avec des premiers matériaux semi-conducteurs de manière à détecter un rayonnement dans une première bande spectrale. Le dispositif de détection comporte également des deuxièmes photodétecteurs qui sont réalisés dans une deuxième architecture qui peut être différente de la première architecture. Les deuxièmes photodétecteurs sont réalisés dans des deuxièmes matériaux semi-conducteurs différents des premiers matériaux semi-conducteurs de manière à détecter le rayonnement dans la deuxième bande spectrale.

Un tel mode de réalisation est compliqué à mettre en œuvre car il nécessite de réaliser deux empilements différents avec des matériaux semi-conducteurs différents pour former deux types de photodétecteurs différents.

En alternative, il est proposé de réaliser des premier et deuxième photodétecteurs qui sont tous les deux sensibles à la première bande spectrale et à la deuxième bande spectrale.

Afin de spécialiser les photodétecteurs sur la première bande spectrale ou sur la deuxième spectrale, des filtres sont associés à chacun des photodétecteurs. Des premiers filtres sont disposés uniquement au-dessus des premiers photodétecteurs de manière à ne laisser passer que la première bande spectrale. Des deuxièmes filtres sont disposés uniquement au-dessus des deuxièmes photodétecteurs de manière à ne laisser passer que la deuxième bande spectrale. Un tel enseignement est décrit dans le document CN203883014.

Cependant, il apparaît qu'un tel mode de réalisation est également très compliqué à mettre en œuvre car il nécessite la réalisation d'un premier filtre au-dessus des premiers photodétecteurs et la réalisation d'un deuxième filtre au-dessus des deuxièmes photodétecteurs. **Il** faut donc réaliser les deux filtres sur le réseau de photodétecteurs.

Un enseignement sensiblement équivalent est décrit dans le document US 2014/0034603. Dans ce document, un filtre multispectral est disposé au-dessus des photodétecteurs. Ce filtre multispectral comporte plusieurs filtres différents ce qui permet de faire passer différentes longueurs d'onde et ainsi dissocier le rayonnement incident.

Un mode de réalisation alternatif est décrit dans le document US 7,109,488 qui décrit un dispositif de détection multicolore dans le domaine de l'infrarouge. Des premiers et seconds pixels sont définis dans un réseau de photodétecteurs. Les premiers et seconds pixels sont définis par des premiers et deuxièmes filtres différents qui sont associés à des photodétecteurs différents.

Le premier filtre permet un passage du rayonnement infrarouge jusqu'à la longueur d'onde de 9 microns. Le photodétecteur est configuré pour détecter un rayonnement compris entre 7 et 9 microns. Le pixel va donc délivrer un signal représentatif du rayonnement compris entre 7 et 9 microns.

Le deuxième filtre autorise le passage du rayonnement infrarouge jusqu'à la longueur d'onde de 10 microns. Le photodétecteur associé est configuré pour détecter un rayonnement compris entre 7 et 9 microns et un rayonnement compris entre 9 et 10 microns. Le deuxième pixel va donc délivrer un signal représentatif du rayonnement compris entre 7 et 10 microns.

Une autre variante de réalisation est décrite dans le document WO 2015/189423 qui traite de capteurs matriciels bispectraux. Ce document propose de réaliser des photodétecteurs identiques pour former un capteur matriciel monotype. Là encore, un système de filtrage complexe permet de spécialiser les photodétecteurs afin qu'une partie des photodétecteurs observe une première bande spectrale et qu'une autre partie des photodétecteurs observe une autre bande spectrale.

Tous les photodétecteurs sont recouverts par un filtre interférentiel bi-bande qui est configuré pour laisser passer les rayonnements d'une première bande spectrale et d'une deuxième bande spectrale.

Une partie de ces photodétecteurs est recouverte par un filtre passe-bas afin de ne recevoir que le rayonnement de la première bande spectrale. L'autre partie de ces photodétecteurs est recouverte par un filtre passe-haut afin de ne recevoir que le rayonnement de la deuxième bande spectrale.

Il apparaît que cette solution est particulièrement complexe à mettre en œuvre et onéreuse.

Le document US 2013/0188057 divulgue un dispositif de capture d'image configuré pour dissocier plusieurs couleurs dans le spectre visible et qui comporte un filtre bloquant le rayonnement infrarouge. Le document EP2117047 divulgue un dispositif de capture de rayonnement visible muni de filtres de couleur et d'un filtre blanc pour dissocier les signaux. Le document EP2827375 de la demanderesse divulgue un dispositif de détection infrarouge monté sur un refroidisseur et associé à un écran froid surmonté d'une lentille.

Le document US 2016/080669 divulgue un capteur de rayonnement visible avec des filtres de différentes couleurs. L'ensemble est surmonté par un filtre infrarouge recouvrant tous les éléments photosensibles. Le document EP2442555 divulgue un capteur d'image qui est muni d'un filtre optique définissant deux bandes de transmissions.

Le document US2005/0189492 divulgue un dispositif de détection infrarouge possédant un réseau de deux pixels associés à un réseau de deux filtres différents pour détecter deux gammes de longueurs d'ondes distinctes. Le réseau de filtres est formé sur un support qui est aligné avec le réseau de pixels pour que le premier pixel reçoive un signal différent du second pixel.

### Objet de l'invention

L'invention a comme objet de fournir un dispositif de détection multispectral qui peut être réalisé plus facilement et qui peut être plus compact.

On tend à atteindre ce résultat au moyen d'un dispositif selon la revendication 1, donc au moyen d'un dispositif de détection multispectrale qui comporte, entre autre :
- un premier photodétecteur et un deuxième photodétecteur sensibles chacun à une première gamme de longueur d'onde et à une deuxième gamme de longueur d'onde différente de la première gamme de longueur d'onde, le premier photodétecteur délivrant un premier signal représentatif du rayonnement reçu et le deuxième photodétecteur délivrant un deuxième signal représentatif du rayonnement reçu,
- un premier filtre configuré pour laisser passer la première gamme de longueur d'onde et pour bloquer la deuxième gamme de longueur d'onde, le premier filtre recouvrant le premier photodétecteur et laissant découvert le deuxième photodétecteur, le premier filtre étant en contact avec le premier photodétecteur de manière à bloquer le passage de la deuxième gamme de longueur d'onde dans le premier photodétecteur,
- un deuxième filtre disposé à distance du premier et du deuxième photodétecteurs et à distance du premier filtre, le deuxième filtre étant configuré pour laisser passer la première gamme de longueur d'onde et la deuxième gamme de longueur d'onde, le deuxième filtre étant configuré pour bloquer une longueur d'onde supérieure à la plus longue des longueurs d'onde parmi les première et deuxième gammes de longueur d'onde et/ou pour bloquer une longueur d'onde inférieure à la plus courte des longueurs d'onde parmi les première et deuxième gammes de longueur d'onde.

Dans un développement, le deuxième photodétecteur est dépourvu de filtre configuré pour bloquer la première gamme de longueur d'onde de manière à recevoir la première gamme de longueur d'onde et la deuxième gamme de longueur d'onde, le dispositif de détection comportant un circuit de traitement configuré pour recevoir des signaux électriques en provenance des premier et deuxième photodétecteurs et fournir une information relative au rayonnement de la deuxième gamme de longueur d'onde par comparaison du premier signal avec le deuxième signal.

En alternative, le deuxième photodétecteur est recouvert par un troisième filtre configuré pour bloquer la première gamme de longueur d'onde et laisser passer la deuxième gamme de longueur d'onde.

Dans un mode de réalisation avantageux, le deuxième filtre est choisi parmi les filtres passe-bas, passe-haut, passe-bande et bi-bande.

Préférentiellement, le premier filtre est un filtre passe-bas, passe-haut ou passe-bande coupant la deuxième gamme de longueur d'onde.

**Il** est intéressant de prévoir que le deuxième filtre est disposé à distance du premier filtre et du deuxième photodétecteur par une couche de gaz ou du vide.

Dans un mode de réalisation, le dispositif de détection comporte un écran froid configuré pour focaliser le rayonnement incident au moyen d'un orifice de passage du rayonnement et le deuxième filtre est disposé dans ledit orifice.

Préférentiellement, l'écran froid définit une enceinte fermée contenant les premier et deuxième photodétecteurs et le deuxième filtre est disposé dans l'enceinte fermée.

En alternative, l'écran froid définit une enceinte fermée contenant les premier et deuxième photodétecteurs et le deuxième filtre est disposé hors de l'enceinte fermée.

L'invention a également comme objet de réaliser un procédé de fabrication d'un dispositif de détection multispectrale qui soit plus simple.

On tend à atteindre ce résultat au moyen d'un procédé de fabrication selon la revendication 10, donc au moyen d'un procédé de fabrication d'un dispositif de détection multispectrale qui comporte, entre autre, les étapes suivantes :
- prévoir un substrat comportant des premier et deuxième photodétecteurs sensibles chacun à une première gamme de longueur d'onde et à une deuxième gamme de longueur d'onde différente de la première gamme de longueur d'onde, le premier photodétecteur délivrant un premier signal représentatif du rayonnement reçu et le deuxième photodétecteur délivrant un deuxième signal représentatif du rayonnement reçu,
- former un premier filtre configuré pour laisser passer la première gamme de longueur d'onde et pour bloquer la deuxième gamme de longueur d'onde, le premier filtre recouvrant le premier photodétecteur et laissant découvert le deuxième photodétecteur, le premier filtre étant en contact avec le premier photodétecteur de manière à bloquer le passage de la deuxième gamme de longueur d'onde dans le premier photodétecteur,
- former un deuxième filtre disposé à distance du premier et du deuxième photodétecteurs et à distance du premier filtre, le deuxième filtre étant configuré pour laisser passer la première gamme de longueur d'onde et la deuxième gamme de longueur d'onde, le deuxième filtre étant configuré pour bloquer une longueur d'onde supérieure à la plus longue des longueurs d'onde parmi les première et deuxième gammes de longueur d'onde et/ou pour bloquer une longueur d'onde inférieure à la plus courte des longueur d'onde parmi les première et deuxième gammes de longueur d'onde.

Dans un développement particulier, le procédé comporte, avant de former le deuxième filtre :
- former un troisième filtre configuré pour laisser passer la deuxième gamme de longueur d'onde et pour bloquer la première gamme de longueur d'onde, le troisième filtre recouvrant le deuxième photodétecteur et laissant découvert le premier photodétecteur, le troisième filtre étant en contact avec le deuxième photodétecteur de manière à bloquer le passage de la première gamme de longueur d'onde dans le deuxième photodétecteur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, de manière schématique, deux modes de réalisation alternatifs d'un dispositif de détection muni de deux photodétecteurs et d'un filtre sur l'écran froid,
- les figures 3a-3f représentent, de manière schématique, des courbes d'intensité, de transmittance et d'absorbance des différents constituants du dispositif de détection selon un premier mode de réalisation,
- les figures 4a-4f représentent, de manière schématique, des courbes d'intensité, de transmittance et d'absorbance des différents constituants du dispositif de détection selon un deuxième mode de réalisation,
- les figures 5a-5f représentent, de manière schématique, des courbes d'intensité, de transmittance et d'absorbance des différents constituants du dispositif de détection selon un troisième mode de réalisation,
- les figures 6a-6f représentent, de manière schématique, des courbes d'intensité, de transmittance et d'absorbance des différents constituants du dispositif de détection selon un quatrième mode de réalisation,
- les figures 7a-7f représentent, de manière schématique, des courbes d'intensité, de transmittance et d'absorbance des différents constituants du dispositif de détection selon un cinquième mode de réalisation,
- les figures 8a-8f représentent, de manière schématique, des courbes d'intensité, de transmittance et d'absorbance des différents constituants du dispositif de détection selon un sixième mode de réalisation,
- les figures 9a-9f représentent, de manière schématique, des courbes d'intensité, de transmittance et d'absorbance des différents constituants du dispositif de détection selon un septième mode de réalisation,
- la figure 10 représente, de manière schématique, un autre mode de réalisation d'un dispositif de détection muni de deux photodétecteurs et d'un filtre sur l'écran froid.

### Description détaillée

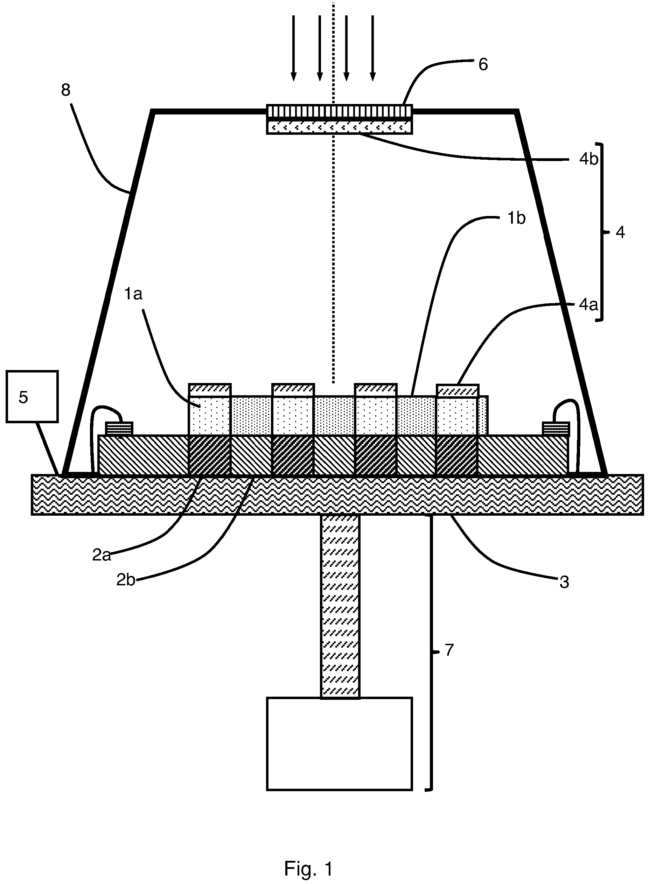

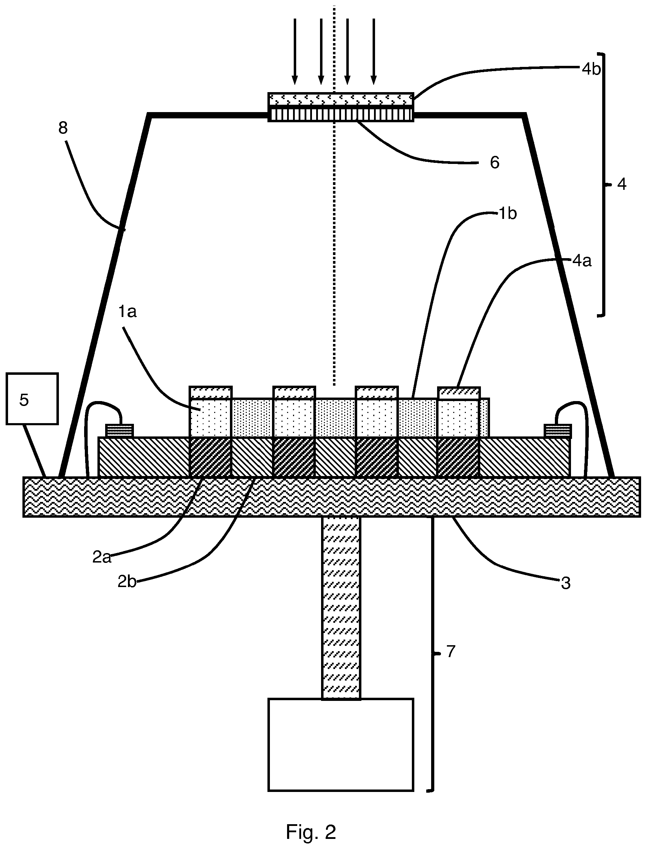

Les figures 1 et 2 illustrent un dispositif de détection multispectrale qui comporte au moins un premier photodétecteur 1a sensible à une première gamme de longueur d'onde également appelée première bande spectrale et un deuxième photodétecteur 1b sensible à une deuxième gamme de longueur d'onde également appelée deuxième bande spectrale.

Dans un mode de réalisation particulier, le premier photodétecteur 1a et le deuxième photodétecteur 1b comportent un seul film semi-conducteur qui est configuré pour absorber la première gamme de longueur d'onde et la deuxième gamme de longueur d'onde. Ce mode de réalisation est particulièrement avantageux car il est très compact.

Dans une variante de réalisation, le premier photodétecteur 1a et le deuxième photodétecteur 1b comportent chacun des premier et deuxième films semi-conducteurs distincts qui sont respectivement configurés pour capter la première gamme de longueur d'onde et la deuxième gamme de longueur d'onde.

Ces deux modes de réalisation sont avantageux car les deux photodétecteurs peuvent être réalisés simultanément ce qui facilite le procédé de fabrication et la densité d'intégration.

Dans un mode de réalisation avantageux, le dispositif de détection multispectrale comporte une pluralité de premiers photodétecteurs et une pluralité de deuxièmes photodétecteurs. De manière avantageuse, les premiers photodétecteurs et les deuxièmes photodétecteurs forment un réseau. **Il** est particulièrement avantageux de prévoir que les premiers photodétecteurs et les deuxièmes photodétecteurs sont uniformément répartis sur la surface de détection.

Dans un mode de réalisation avantageux, la pluralité de premiers photodétecteurs et la pluralité de deuxièmes photodétecteurs forment un réseau plan focal, c'est-à-dire que tous les photodétecteurs sont réalisés dans un même plan.

De manière préférentielle, le dispositif de détection comporte autant de premiers photodétecteurs que de deuxièmes photodétecteurs. En alternative, il est également possible de prévoir que le dispositif de détection comporte un nombre de premiers photodétecteurs qui est différent du nombre de deuxièmes photodétecteurs.

Dans un mode de réalisation particulier, la deuxième gamme de longueur d'onde est différente de la première gamme de longueur d'onde. De manière avantageuse, la deuxième gamme de longueur d'onde est dissociée de la première gamme de longueur d'onde c'est-à-dire que les gammes de longueur d'onde ne se chevauchent pas. Selon les modes de réalisation, les première et deuxième gammes de longueur d'onde ont une borne commune ou elles sont séparées par une gamme de longueur d'onde intermédiaire.

Le premier photodétecteur 1a et le deuxième photodétecteur 1b sont tous les deux sensibles à la première gamme de longueur d'onde et à la deuxième gamme de longueur d'onde. En d'autres termes, le premier photodétecteur 1a et le deuxième photodétecteur 1b sont en mesure de capter le rayonnement émis dans la première gamme de longueur d'onde et de fournir un signal électrique représentatif de ce rayonnement. Le premier photodétecteur 1a et le deuxième photodétecteur 1b sont également en mesure de capter le rayonnement émis dans la deuxième gamme de longueur d'onde et de fournir un signal électrique représentatif de ce rayonnement.

Il est également possible que le premier photodétecteur 1a et le deuxième photodétecteur 1b soient en mesure de capter le rayonnement émis dans une troisième gamme de longueur d'onde qui est différente des première et deuxième gammes de longueur d'onde. Cette troisième gamme de longueur d'onde ne contient pas d'information pertinente, mais elle permet de faciliter la réalisation des photodétecteurs en choisissant des matériaux semi-conducteurs plus faciles à utiliser.

Les première et deuxième gammes de longueur d'onde sont des gammes du rayonnement infrarouge. Dans un mode de réalisation particulier, la première gamme de longueur d'onde et la deuxième gamme de longueur d'onde sont choisies parmi les gammes suivantes :
NIR : entre 0,8µm et 1,4µm
SWIR : entre 1,4µm et 3µm,
MWIR : entre 3µm et 8µm,
LWIR : entre 8µm et 15µm.

Il est donc possible de configurer le dispositif de détection afin que ce dernier puisse détecter différents couples de gammes de longueur d'onde, par exemple MWIR/LWIR, MWIR/SWIR, LWIR/SWIR, NIR/SWIR, NIR/LWIR ou NIR/MWIR.

Il est encore possible de découper les différentes gammes présentées cidessus en deux sous-gammes différentes. Dans un mode de réalisation particulier, les première et deuxième gammes de longueur d'onde divisent par exemple le rayonnement MWIR en deux sous-gammes distinctes. Il peut en être de même pour les rayonnements LWIR, SWIR ou NIR.

Le premier et le deuxième photodétecteurs 1a et 1b peuvent être formés par tout type de détecteur adapté, par exemple par une photodiode, un détecteur à puits quantique ou un détecteur à multipuits quantiques. D'autres types de photodétecteurs sont également possibles. Les premier et deuxième photodétecteurs 1a et 1b peuvent être réalisés dans des architectures identiques ou différentes. De manière avantageuse, le premier photodétecteur 1a est identique au deuxième photodétecteur 1b, c'est-à-dire dans les matériaux et dans l'architecture de réalisation. Il est alors beaucoup plus facile de réaliser les photodétecteurs de manière compacte.

Les conditions d'alimentation des photodétecteurs 1a et 1b peuvent être différentes. Avantageusement, les conditions d'alimentation sont identiques pour tous les photodétecteurs. Les conditions d'alimentation sont fournies par un premier circuit de lecture 2a pour le premier photodétecteur 1a et par un deuxième circuit de lecture 2b pour le deuxième photodétecteur 1b.

Les photodétecteurs 1a et 1b et les circuits de lecture 2a et 2b sont avantageusement disposé sur un support 3.

Afin de spécialiser les premier et deuxième photodétecteurs 1a et 1b, les photodétecteurs sont associés à un système de filtrage 4 du rayonnement incident. Le système de filtrage 4 est configuré pour que le premier photodétecteur 1a reçoive un rayonnement différent du deuxième photodétecteur 1b. De cette manière, les deux photodétecteurs 1a et 1b sont en mesure de fournir deux informations différentes sur la scène observée.

Comme indiqué plus haut, l'utilisation de photodétecteurs identiques permet de faciliter la réalisation d'un dispositif compact. Cependant, la compacité est telle qu'il devient difficile de réaliser des filtres différents et performants au-dessus du premier photodétecteur 1a et au-dessus du deuxième photodétecteur 1b.

Afin de faciliter la réalisation d'un dispositif de détection performant, le système de filtrage 4 est un système de filtrage dissocié, c'est-à-dire qu'il comporte au moins un premier filtre 4a et un deuxième filtre 4b qui présentent des propriétés optiques différentes et qui sont disposés successivement dans le chemin optique du premier photodétecteur 1a. Le premier filtre 4a et le deuxième filtre 4b ne sont pas en contact l'un avec l'autre ce qui permet de faciliter la réalisation du système de filtrage 4. Le premier filtre 4a présente des caractéristiques optiques et préférentiellement mécaniques différentes du deuxième filtre 4b.

L'utilisation de deux filtres dissociés et consécutifs dans le chemin optique permet de réduire l'épaisseur du filtre disposé en contact avec le photodétecteur en comparaison d'un filtre équivalent qui est également en contact avec le photodétecteur.

Typiquement, l'épaisseur d'un filtre est sensiblement égale à la longueur d'onde de la fréquence de coupure. Ainsi, pour un photodétecteur configuré pour absorber un rayonnement dans la gamme 3-5µm, le filtre équivalent présente une épaisseur sensiblement comprise entre 3µm et 5µm.

Il apparaît clairement qu'une telle épaisseur pose un problème de fabrication pour les réseaux de photodétecteurs dont le pas de répétition est inférieur à 30µm. Le problème d'intégration est encore plus critique pour les réseaux de photodétecteurs dont le pas de répétition est inférieur à 20µm. Des problèmes importants de réalisation sont présents pour les réseaux de photodétecteurs dont le pas de répétition est inférieur à 15µm et notamment lorsque le filtre possède une épaisseur égale à 5µm.

Il apparaît encore que pour accroitre les performances du filtre et notamment pour accroitre sa capacité à bloquer efficacement une partie du rayonnement incident, le nombre de couches formant le filtre doit être augmenté ce qui augmente l'épaisseur du filtre. Par exemple, pour accroitre le pouvoir de réjection du filtre, c'est-à-dire sa capacité à bloquer le rayonnement incident de 10% par rapport à un filtre de référence, l'augmentation de l'épaisseur est de l'ordre de 2µm.

Il apparaît également que pour les dispositifs de détection qui fonctionnent à basse température, typiquement en dessous de 0°C, le filtre introduit des contraintes thermomécaniques importantes dans le photodétecteur ce qui dégrade les performances du dispositif de détection. Les contraintes thermomécaniques augmentent lorsque l'épaisseur augmente.

Le système de filtrage 4 comporte un premier filtre 4a qui est configuré pour laisser passer la première gamme de longueur d'onde et pour bloquer la deuxième gamme de longueur d'onde. Le premier filtre 4a peut être un filtre interférentiel ou un filtre à absorption.

Selon les modes de réalisation, la première gamme de longueur d'onde peut présenter des longueurs d'onde plus longues ou plus courtes que la deuxième gamme de longueur d'onde. Le premier filtre 4a peut donc être un filtre passe-bas ou un filtre passe-haut dont la longueur d'onde de coupure se trouve entre la première gamme de longueur d'onde et la deuxième gamme de longueur d'onde. Ce mode de réalisation est particulièrement avantageux car les filtres passe-bas et passe-haut sont faciles à réaliser ce qui simplifie leur intégration à la surface des photodétecteurs. Ils sont généralement moins épais que les autres filtres.

En alternative, il est également possible de prévoir que le premier filtre 4a est un filtre passe-bande qui laisse passer la première gamme de longueur d'onde et qui bloque la deuxième gamme de longueur d'onde. Ce mode de réalisation est légèrement moins avantageux que le précédent car un filtre passe-bande est généralement plus épais qu'un filtre passe-bas ou passe-haut.

Le premier filtre 4a est un filtre qui est déposé directement sur le premier photodétecteur 1a, c'est-à-dire sur une partie du réseau plan focal. Le premier filtre 4a n'est pas déposé sur le deuxième photodétecteur 1b ainsi le premier filtre 4a vient recouvrir le premier photodétecteur 1a et il laisse découvert le deuxième photodétecteur 1b. Le premier filtre 4a est en contact physique avec le premier photodétecteur 1a. Le premier filtre 4a permet de limiter la diaphonie (ou crosstalk en langue anglaise) entre le premier photodétecteur 1a et le deuxième photodétecteur adjacent 1b.

Au moyen de cette configuration particulière, le premier photodétecteur 1a ne reçoit qu'une partie du rayonnement incident. Le premier photodétecteur 1a reçoit la première gamme longueur d'onde et il ne reçoit pas la deuxième gamme longueur d'onde.

Afin d'éliminer efficacement les rayonnements parasites, le système de filtrage 4 comporte également un deuxième filtre 4b. Le deuxième filtre 4b est utilisé pour bloquer une partie du rayonnement incident avant d'être capté par les premier et deuxième photodétecteurs 1a et 1b. De manière plus précise, le deuxième filtre 4b est utilisé pour bloquer une partie du rayonnement incident avant de frapper le plan focal et notamment le premier filtre 4a qui va bloquer une autre partie du rayonnement incident.

Le deuxième filtre 4b est disposé à distance du premier photodétecteur 1a et du deuxième photodétecteur 1b, c'est-à-dire que le deuxième filtre 4b n'est pas en contact direct avec le premier photodétecteur 1a, ni avec le deuxième photodétecteur 1b.

Le deuxième filtre 4b est déposé sur un deuxième substrat qui est différent du premier substrat supportant les premier et deuxième photodétecteurs ou sur lequel sont formés les premier et deuxième photodétecteurs.

Selon les modes de réalisation, le deuxième filtre 4b peut être un filtre interférentiel ou un filtre à absorption.

Le premier filtre 4a et le deuxième filtre 4b travaillent en association pour filtrer le rayonnement reçu par le premier photodétecteur 1a.

En séparant le premier filtre 4a et le deuxième filtre 4b, il est possible d'obtenir un filtre global capable de ne laisser passer que le rayonnement pertinent en direction du premier photodétecteur tout en limitant l'épaisseur du premier filtre 4a formé directement sur le premier photodétecteur. De cette manière, il est possible de former des premiers filtres plus compacts.

Le deuxième filtre 4b est séparé des photodétecteurs 1a et 1b et du premier filtre 4a par une couche de gaz ou de vide. De cette manière, les contraintes thermomécaniques liées au deuxième filtre 4b sont fortement réduites voire annulées. Il est alors plus facile de former le premier filtre 4a et le deuxième filtre 4b. L'épaisseur du premier filtre peut être réduite ce qui diminue les contraintes thermomécaniques.

Dans un mode de réalisation particulier, le deuxième filtre 4b est avantageusement reporté sur le substrat contenant le premier photodétecteur 1a et le deuxième photodétecteur 1b. Le deuxième filtre 4b peut alors être formé séparément du premier filtre 4a et le procédé de réalisation du deuxième filtre 4b n'interfère pas avec le premier filtre 4a, ni avec les photodétecteurs 1a et 1b.

Dans une variante de réalisation, le deuxième filtre 4b est avantageusement reporté sur le support 3 qui est configuré pour supporter le substrat contenant le premier photodétecteur 1a et le deuxième photodétecteur 1b. Là encore, le deuxième filtre 4b peut alors être formé séparément du premier filtre 4a et le procédé de réalisation du deuxième filtre 4b n'interfère pas avec le premier filtre 4a, ni avec les photodétecteurs 1a et 1b.

Le deuxième filtre 4b étant disposé à distance du premier filtre 4a et des photodétecteurs 1a et 1b. Le deuxième filtre 4b est un filtre commun au premier photodétecteur 1a et au deuxième photodétecteur 1b. De cette manière, le deuxième filtre 4b n'est pas lié à une contrainte d'alignement par rapport au premier filtre 4a, ni au deuxième photodétecteur 1b. Le deuxième filtre 4b se trouve entre la source de rayonnement et le premier filtre 4a ainsi que entre la source de rayonnement et le deuxième photodétecteur 1b. Le deuxième filtre 4b étant disposé à distance du premier filtre 4a et des photodétecteurs, les contraintes de fabrications et d'intégration sont réduites en comparaison des dispositifs de l'art antérieur.

Le deuxième filtre 4b est configuré pour laisser passer la première gamme de longueur d'onde et la deuxième gamme de longueur d'onde. Le deuxième filtre 4b est avantageusement configuré pour bloquer la troisième gamme de longueur d'onde qui est différente des première et deuxième gammes de longueur d'onde.

De manière avantageuse, le deuxième filtre 4b est un filtre coupe-bande. Il est également possible de réaliser un filtre passe-bas ou passe-haut ou bi-lobe.

Selon les modes de réalisation, de façon non exhaustive, le deuxième filtre 4b peut être configuré pour bloquer les longueurs d'onde à l'extérieur des gammes suivantes :
0,8µm - 3µm, pour capter les rayonnements NIR et SWIR,
1,4µm - 8µm, pour capter les rayonnements SWIR et MWIR,
3µm - 15µm, pour capter les rayonnements MWIR et LWIR,
0,8µm - 1,4µm, pour capter le rayonnement NIR,
1,4µm - 3µm, pour capter le rayonnement SWIR,
3µm - 8µm, pour capter le rayonnement MWIR,
8µm - 15µm, pour capter le rayonnement LWIR,

De cette manière, le système de filtrage 4 empêche certaines longueurs d'onde d'atteindre les premier et deuxième photodétecteurs 1a/1b et de polluer les signaux utiles reçus.

Dans un mode de réalisation particulier, le deuxième photodétecteur 1b est dépourvu de filtre disposé en contact direct avec sa surface. Dans cette configuration, le deuxième photodétecteur 1b reçoit la première longueur d'onde et la deuxième longueur d'onde car il n'est pas associé au premier filtre 4a. Ce mode de réalisation est particulièrement avantageux car seul le premier photodétecteur 1a est recouvert d'un premier filtre 4a ce qui facilite la réalisation du dispositif de détection avec des photodétecteurs de faibles dimensions.

Le premier photodétecteur 1a émet un signal électrique qui est représentatif du rayonnement reçu. Le signal électrique en provenance du premier photodétecteur 1a est représentatif du rayonnement dans la première gamme de longueur d'onde uniquement.

Le deuxième photodétecteur 1b émet également un signal électrique qui est représentatif du rayonnement reçu. Le signal électrique en provenance du deuxième photodétecteur 1b est représentatif du rayonnement dans la première gamme de longueur d'onde et dans la deuxième gamme de longueurs d'onde.

Afin d'obtenir un signal représentatif du rayonnement dans la deuxième gamme de longueur d'onde, il est avantageux de comparer le signal électrique en provenance du premier photodétecteur 1a avec le signal électrique du deuxième photodétecteur 1b.

Les différences d'informations entre les deux signaux sont représentatives du rayonnement dans la deuxième gamme de longueur d'onde.

De manière avantageuse, le premier photodétecteur 1a est connecté à un circuit de lecture/traitement 5 qui reçoit le premier signal électrique. Le deuxième photodétecteur 1b est également connecté au circuit de lecture/traitement 5 qui reçoit le deuxième signal électrique. Le circuit de lecture/traitement 5 est configuré pour comparer le premier signal électrique par rapport au deuxième signal électrique et pour fournir un troisième signal représentatif du rayonnement reçu par le deuxième photodétecteur 1b dans la deuxième gamme de longueur d'onde. Dans un mode de réalisation, le circuit de lecture/traitement peut être réalisé dans le substrat 3. Il est encore possible de dissocier les fonctions lecture et traitement et de réaliser la fonction de lecture dans le support 3. La fonction traitement est alors réalisée à part.

Il est avantageux d'utiliser un deuxième filtre 4b qui est un filtre passe-haut ou un filtre passe-bas. Le deuxième filtre 4b est alors configuré pour laisser passer la première gamme de longueur d'onde et la deuxième gamme de longueur d'onde et pour bloquer une longueur d'onde supérieure à la plus grande des longueurs d'onde parmi les première et deuxième gammes de longueur d'onde ou pour bloquer la longueur d'onde inférieure à la plus petite des longueurs d'onde parmi les première et deuxième gammes de longueur d'onde.

Il est également avantageux d'utiliser un deuxième filtre 4b dont la longueur d'onde de coupure correspond à une extrémité de l'ensemble formé par la première et la deuxième gammes de longueur d'onde. De cette manière, une partie des aléas de fabrication des photodétecteurs est éliminée.

Il est particulièrement avantageux de prévoir l'utilisation d'un deuxième filtre 4b qui est un filtre passe-bande dont la longueur d'onde de coupure inférieure et la longueur d'onde de coupure supérieure correspondent aux extrémités de l'intervalle défini par les première et deuxième gammes de longueur d'onde. De cette manière, une partie des aléas de fabrication des photodétecteurs est éliminée.

En variante, le deuxième filtre 4b peut être un filtre bi-lobe également appelé bi-bande qui est plus compliqué à réaliser et qui est plus épais. Le filtre bi-lobe est configuré pour laisser passer la première gamme de longueur d'onde et la deuxième gamme de longueur d'onde. Ce filtre permet une meilleure sélection des longueurs d'onde utiles. La complexité de réalisation et son épaisseur plus importante ne sont plus des problèmes car le filtre est déporté par rapport aux photodétecteurs.

Le deuxième filtre 4b permet de laisser passer la première gamme de longueur d'onde et la deuxième gamme de longueur d'onde et d'exclure, au moins en partie voire totalement, le rayonnement dans les gammes de longueur d'onde non recherchées.

Les inventeurs ont observé que ce mode de réalisation est particulièrement avantageux par rapport aux réalisations de l'art antérieur. En effet dans les documents de l'art antérieur, il est proposé de réaliser un premier filtre sur le premier photodétecteur et un deuxième filtre différent sur le deuxième photodétecteur.

Les deux filtres utilisés ont des épaisseurs conséquentes qui peuvent être du même ordre de grandeur que la dimension latérale du photodétecteur. Il est donc difficile de bien maitriser la réalisation d'une matrice de détection avec un pas faible entre les photodétecteurs.

En utilisant un seul filtre, ici le premier filtre 4a, pour spécialiser les premiers photodétecteurs par rapport aux deuxièmes photodétecteurs, il est plus facile de réaliser une matrice de détection avec un pas de répétition faible. Les contraintes d'alignement sont limitées au premier filtre 4a dans le procédé de fabrication.

L'utilisation d'un seul premier filtre 4a qui est configuré pour laisser passer la première gamme de longueur d'onde et bloquer la deuxième gamme de longueur d'onde a l'avantage d'être simple à réaliser. Il n'y a plus les contraintes liées aux étapes ultérieures de dépôt et gravure ou par décollement (lift-off en langue anglaise) pour former un autre filtre sur le substrat contenant les photodétecteurs. Le premier filtre 4a peut être un filtre mince et les étapes technologiques pour former ce premier filtre sont réduites ce qui réduit d'autant les risques de détérioration du premier et/ou du deuxième photodétecteurs.

Il est particulièrement avantageux de choisir le filtre passe-bas, passe-haut ou passe bande qui est le plus facile à réaliser et/ou le moins épais afin de bloquer une partie du rayonnement incident et ainsi spécialiser le premier photodétecteur 1a par rapport au deuxième photodétecteur 1b.

Dans un mode de réalisation particulier, une couche anti-reflet (non représentée) est utilisée. Selon les modes de réalisation, la couche anti-reflet peut être disposée sur le deuxième filtre 4b, c'est-à-dire que le deuxième filtre 4b vient séparer la couche anti-reflet et les photodétecteurs 1a et 1b. En variante, la couche anti-reflet est déposée sur le deuxième photodétecteur 1b et sur le premier filtre 4a. La couche anti-reflet vient séparer le deuxième filtre 4b et le premier filtre 4a. De manière avantageuse, une première couche anti-reflet est déposée sur les photodétecteurs 1a et 1b et une deuxième couche anti-reflet est déposée sur le deuxième filtre 4b ou en contact avec le deuxième filtre 4b. Selon les modes de réalisation, la couche anti-reflet peut être déposée sur le premier filtre ou entre le premier photodétecteur 1a et le premier filtre 4a. La couche antireflet est avantageusement configurée pour laisser passer le rayonnement infrarouge.

Une couche de passivation est utilisée pour recouvrir le premier et/ou le deuxième photodétecteurs 1a et 1b. La couche de passivation est disposée entre le premier photodétecteur 1a et le premier filtre 4a. La couche de passivation présente une épaisseur comprise entre 10nm et 2000nm. L'utilisation d'une couche de passivation est particulièrement avantageuse pour limiter la pollution de la bande non-filtrée. Par exemple, la pollution de la bande non-filtrée peut se traduire par de la contamination avec des éléments extérieurs au dispositif ou par la diffusion de contaminants. La couche de passivation permet d'écarter les contaminants hors des photodétecteurs et/ou hors des filtres afin de ne pas modifier les performances optiques et/ou électriques. Les contaminants sont par exemple de l'or ou du cuivre.

Le dispositif de détection comporte une couche de passivation continue qui recouvre les premier et deuxième photodétecteurs 1a et 1b de manière monolithique. La couche de passivation continue permet une meilleure gestion des contraintes thermomécaniques en lissant les contraintes sur les premier et deuxième photodétecteur. Il est particulièrement avantageux de prévoir que le matériau utilisé pour former la couche de passivation est un matériau présentant un faible coefficient de diffusion des espèces contaminantes.

Dans un mode de réalisation particulier, un promoteur d'accroche est disposé entre les photodétecteurs et/ou filtres et la couche de passivation.

Dans un mode de réalisation particulier, la couche de passivation est réalisée dans un matériau choisi parmi Ge, ZnS, CdTe, SiO_{X}, SiNₓ de manière à former simultanément une couche de passivation et une couche antireflet. La couche antireflet peut être constituée par une seule couche dans un seul matériau ou par un empilement de plusieurs couches dans des matériaux différents.

Les inventeurs ont également observé qu'il est avantageux d'utiliser des premier et deuxième photodétecteurs qui sont sensibles à la première gamme de longueur d'onde, à la deuxième gamme de longueur d'onde et qui ne sont pas sensibles entre ces deux gammes de longueurs d'onde. Ainsi, la spécialisation du premier photodétecteur 1a par rapport au deuxième photodétecteur 1b est facile à réaliser car la contrainte sur la fréquence de coupure du premier filtre 4a est réduite.

Ce mode de réalisation est également avantageux car les contraintes sur le deuxième filtre 4b sont également réduites.

Cependant, dans de nombreux cas de figure, les photodétecteurs sont sensibles à au moins une troisième gamme de longueur d'onde qui est située entre la première et la deuxième gamme de longueur d'onde. Il est alors avantageux d'utiliser un filtre bi-lobe.

Il apparaît qu'utiliser un photodétecteur ayant une sensibilité qui s'étend au-delà de la première gamme de longueur d'onde et au-delà de la deuxième gamme de longueur d'onde permet de relâcher certaines contraintes technologiques qui sont liées aux procédés de fabrication des photodétecteurs et/ou aux matériaux utilisés.

Cependant, utiliser des photodétecteurs sensibles hors de la première gamme de longueur d'onde et hors de la deuxième gamme de longueur d'onde se traduit par l'adjonction de signaux parasites en provenance de gammes de rayonnements non désirées.

Le système de filtrage 4 est configuré pour bloquer cette troisième gamme de longueur d'onde. Plus particulièrement, la troisième gamme de longueur d'onde est bloquée par le deuxième filtre 4b.

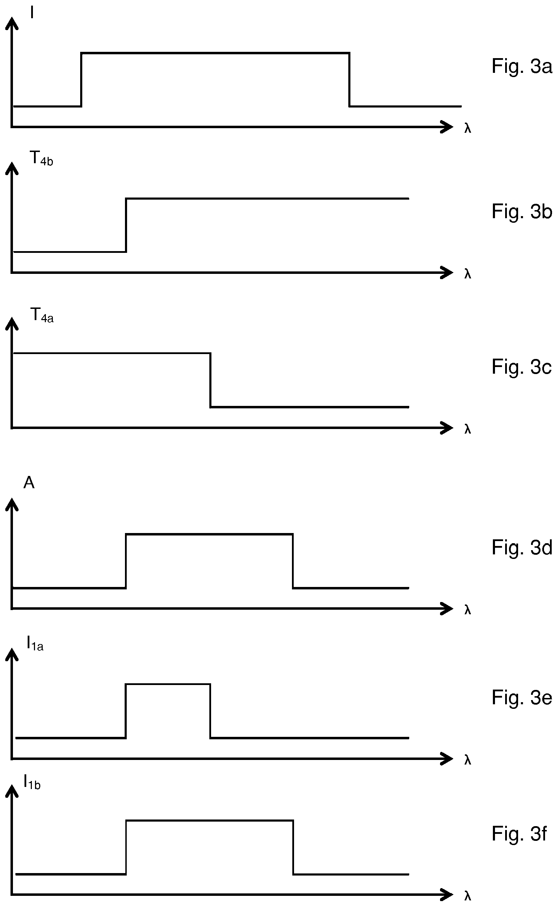

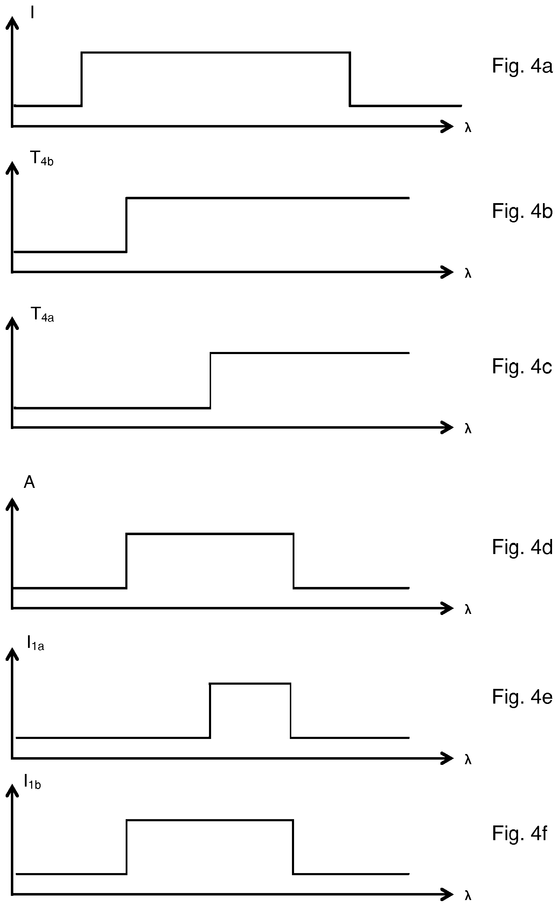

Dans un mode de réalisation particulièrement avantageux et illustré par les courbes de transmission des figures 3b et 4b, le deuxième filtre 4b est un filtre passe-haut qui est configuré pour couper les longueurs d'onde en dessous de l'extrémité inférieure de l'intervalle défini par les première et deuxième gammes de longueur d'onde. Un tel filtre permet de bloquer le rayonnement parasite qui correspond aux longueurs d'onde inférieures à la longueur d'onde de coupure et qui peut être absorbé par les photodétecteurs 1a et 1b.

Dans ce cas de figure, le premier filtre 4a peut être un filtre passe-haut, un filtre passe-bas ou un filtre passe-bande.

Si le premier filtre 4a est un filtre passe-bas dont la courbe de transmission est illustrée à la figure 3c, la première gamme de longueur d'onde présente des longueurs d'onde plus courtes que la deuxième gamme de longueur d'onde. Le premier photodétecteur 1a ne reçoit que la gamme de longueur d'onde associée aux longueurs d'onde les plus courtes comme cela est illustré avec la courbe d'intensité de la figure 3e. Le deuxième photodétecteur 1b reçoit les deux gammes de longueur d'onde comme cela est illustré avec la courbe d'intensité de la figure 3f. La figure 3d représente la gamme de longueur d'onde d'absorption des premier et deuxième photodétecteurs 1a et 1b.

Si le premier filtre 4a est un filtre passe-haut dont la courbe de transmission est illustrée à la figure 4c, la première gamme de longueur d'onde présente des longueurs d'onde plus longues que la deuxième gamme de longueur d'onde. Le premier photodétecteur 1a ne reçoit que la gamme de longueur d'onde associée aux longueurs d'onde les plus longues comme cela est illustré avec la courbe d'intensité de la figure 4e. Le deuxième photodétecteur 1b reçoit les deux gammes de longueur d'onde comme cela est illustré avec la courbe d'intensité de la figure 4f. La figure 4d représente la gamme de longueur d'onde d'absorption des premier et deuxième photodétecteurs 1a et 1b.

Si le premier filtre 4a est un filtre passe-bande (non représenté), la première gamme de longueur d'onde peut présenter des longueurs d'onde plus courtes ou plus longues que la deuxième gamme de longueur d'onde selon les caractéristiques du premier filtre 4a. Si le premier filtre 4a est configuré pour laisser passer les longueurs d'onde les plus courtes alors le fonctionnement est équivalent à un filtre passe-bas. Si le premier filtre 4a est configuré pour laisser passer les longueurs d'onde les plus longues alors le fonctionnement est équivalent à un filtre passe-haut.

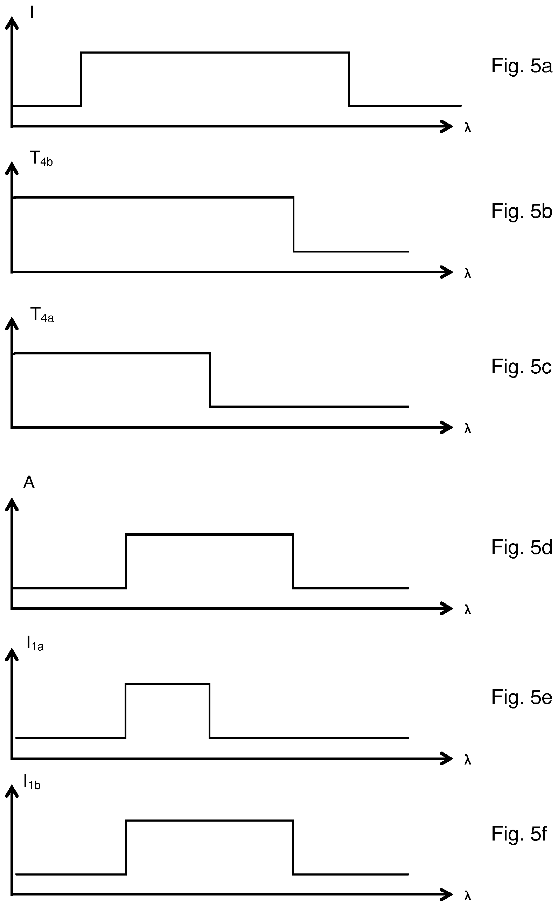

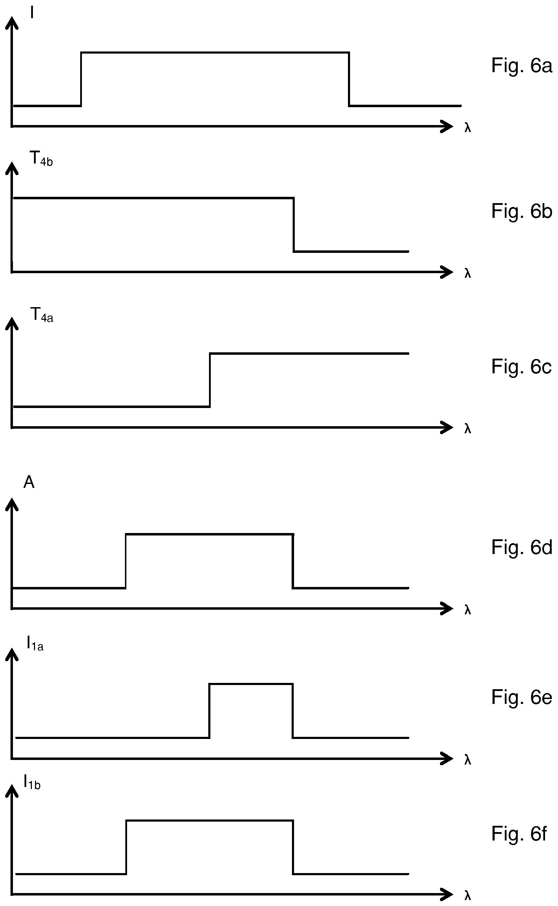

Dans un autre mode de réalisation illustré par les courbes de transmission des figures 5b et 6b, le deuxième filtre 4b est un filtre passe-bas qui est configuré pour couper les longueurs d'onde au-dessus de l'extrémité supérieure de l'intervalle défini par les première et deuxième gammes de longueur d'onde. Un tel filtre permet de bloquer le rayonnement parasite qui correspond aux longueurs d'onde supérieures à la longueur d'onde de coupure et qui peut être absorbé par les photodétecteurs 1a et 1b (figure 5d).

Dans ce cas de figure, le premier filtre 4a peut être un filtre passe-haut, un filtre passe-bas ou un filtre passe-bande.

Si le premier filtre 4a est un filtre passe-bas dont la courbe de transmission est illustrée à la figure 5c, la première gamme de longueur d'onde présente des longueurs d'onde plus courtes que la deuxième gamme de longueur d'onde. Le premier photodétecteur 1a ne reçoit que la gamme de longueur d'onde associée aux longueurs d'onde les plus courtes comme cela est illustré avec la courbe d'intensité de la figure 5e. Le deuxième photodétecteur 1b reçoit les deux gammes de longueur d'onde comme cela est illustré avec la courbe d'intensité de la figure 5f. La figure 5d représente la gamme de longueur d'onde d'absorption des premier et deuxième photodétecteurs 1a et 1b.

Si le premier filtre 4a est un filtre passe-haut dont la courbe de transmission est illustrée à la figure 6c, la première gamme de longueur d'onde présente des longueurs d'onde plus longues que la deuxième gamme de longueur d'onde. Le premier photodétecteur 1a ne reçoit que la gamme de longueur d'onde associée aux longueurs d'onde les plus longues comme cela est illustré avec la courbe d'intensité de la figure 6e. Le deuxième photodétecteur 1b reçoit les deux gammes de longueur d'onde comme cela est illustré avec la courbe d'intensité de la figure 6f. La figure 6d représente la gamme de longueur d'onde d'absorption des premier et deuxième photodétecteurs 1a et 1b.

Si le premier filtre 4a est un filtre passe-bande (non représenté), la première gamme de longueur d'onde peut présenter des longueurs d'onde plus courtes ou plus longues que la deuxième gamme de longueur d'onde selon les caractéristiques du premier filtre 4a. Si le premier filtre 4a est configuré pour laisser passer les longueurs d'onde les plus courtes alors le fonctionnement est équivalent à un filtre passe-bas. Si le premier filtre 4a est configuré pour laisser passer les longueurs d'onde les plus longues alors le fonctionnement est équivalent à un filtre passe-haut.

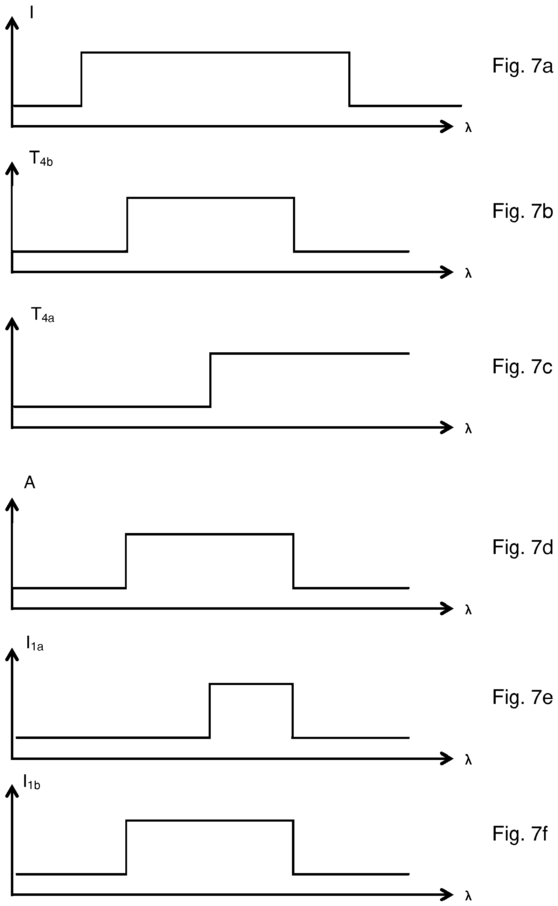

Dans un mode de réalisation particulièrement avantageux illustré par la courbe de transmission de la figure 7b, le deuxième filtre 4b est un filtre passe-bande qui est configuré pour couper les longueurs d'onde en dessous de l'extrémité inférieure de l'intervalle défini par les première et deuxième gammes de longueur d'onde et pour couper les longueurs d'onde au-dessus de l'extrémité supérieure de l'intervalle défini par les première et deuxième gammes de longueur d'onde. Un tel filtre permet de bloquer les rayonnements parasites qui correspondent aux longueurs inférieures et supérieures aux deux longueurs d'onde de coupure et qui peuvent être absorbés par les photodétecteurs 1a et 1b (figure 7d).

Dans ce cas de figure, le premier filtre 4a peut être un filtre passe-haut, un filtre passe-bas ou un filtre passe-bande.

Si le premier filtre 4a est un filtre passe-haut dont la courbe de transmission est illustrée à la figure 7c, la première gamme de longueur d'onde présente des longueurs d'onde plus longues que la deuxième gamme de longueur d'onde. Le premier photodétecteur 1a ne reçoit que la gamme de longueur d'onde associée aux longueurs d'onde les plus longues comme cela est illustré avec la courbe d'intensité de la figure 7e. Le deuxième photodétecteur 1b reçoit les deux gammes de longueur d'onde comme cela est illustré avec la courbe d'intensité de la figure 7f. La figure 7d représente la gamme de longueur d'onde d'absorption des premier et deuxième photodétecteurs 1a et 1b.

Si le premier filtre 4a est un filtre passe-bas (non représenté), la première gamme de longueur d'onde présente des longueurs d'onde plus courtes que la deuxième gamme de longueur d'onde. Le premier photodétecteur 1a ne reçoit que la gamme de longueur d'onde associée aux longueurs d'onde les plus courtes. Le deuxième photodétecteur 1b reçoit les deux gammes de longueur d'onde.

Si le premier filtre 4a est un filtre passe-bande (non représenté), la première gamme de longueur d'onde peut présenter des longueurs d'onde plus courtes ou plus longues que la deuxième gamme de longueur d'onde selon les caractéristiques du premier filtre 4a. Si le premier filtre 4a est configuré pour laisser passer les longueurs d'onde les plus courtes alors le fonctionnement est équivalent à un filtre passe-bas. Si le premier filtre 4a est configuré pour laisser passer les longueurs d'onde les plus longues alors le fonctionnement est équivalent à un filtre passe-haut.

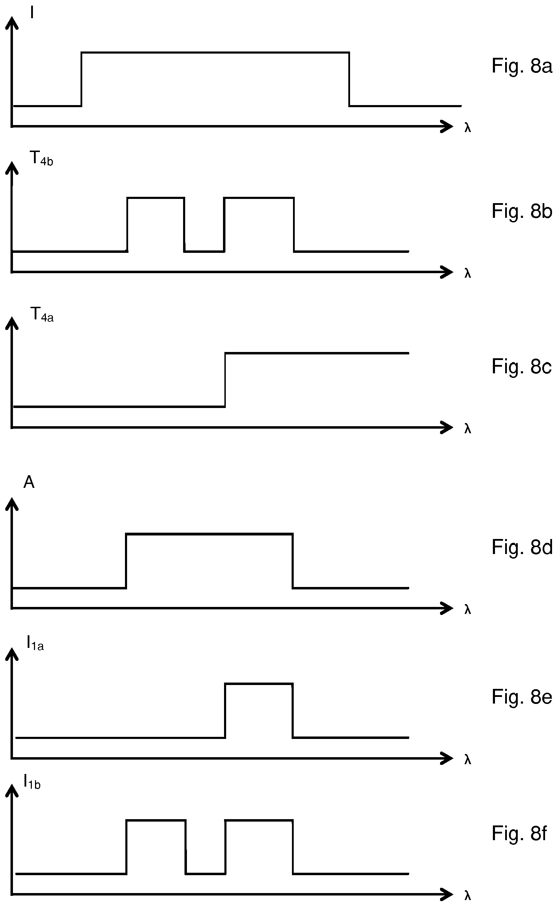

Dans un mode de réalisation illustré aux figures 8a à 8f, le deuxième filtre 4b est un filtre bi-lobe dont la courbe de transmission est illustrée à la figure 8b. Le filtre bi-lobe est associé à un premier filtre 4a de type passe-haut dont la courbe de transmission est illustrée à la figure 8c. Le premier photodétecteur 1a ne reçoit que la gamme de longueur d'onde associée aux longueurs d'onde les plus longues comme cela est illustré avec la courbe d'intensité de la figure 8e. Le deuxième photodétecteur 1b reçoit les deux gammes de longueur d'onde comme cela est illustré avec la courbe d'intensité de la figure 8f. La figure 8d représente la gamme de longueur d'onde d'absorption des premier et deuxième photodétecteurs 1a et 1b.

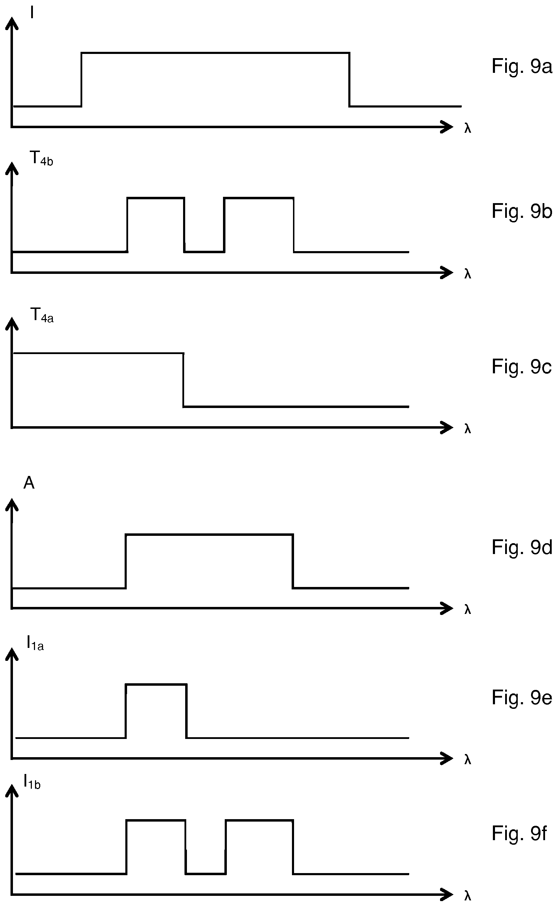

Comme pour les autres modes de réalisation, le premier filtre 4a peut être remplacé par un filtre passe-bande ou par un filtre passe-bas qui est illustré par les figures 9a à 9f.

Les figures 3a, 4a, 5a 6a, 7a, 8a et 9a représentent l'intensité lumineuse de la scène observée.

La courbe de transmission du filtre passe-bas est illustrée à la figure 9c. Le premier photodétecteur 1a ne reçoit que la gamme de longueur d'onde associée aux longueurs d'onde les plus courtes comme cela est illustré avec la courbe d'intensité de la figure 9e. Le deuxième photodétecteur 1b reçoit les deux gammes de longueur d'onde comme cela est illustré avec la courbe d'intensité de la figure 9f. La figure 9d représente la gamme de longueur d'onde absorbée par les premier et deuxième photodétecteurs 1a et 1b.

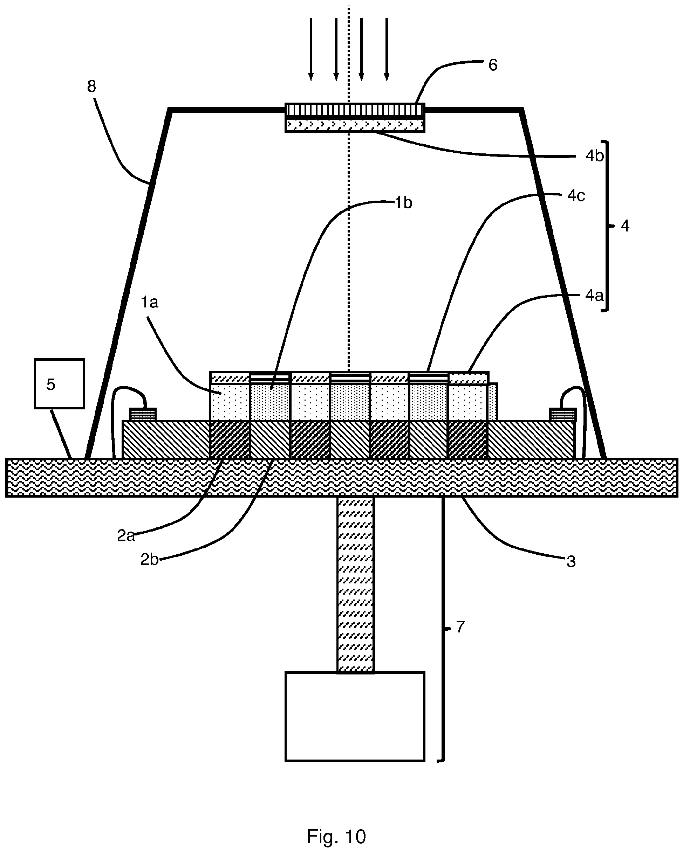

Dans un mode de réalisation alternatif illustré à la figure 10, le deuxième photodétecteur 1b est recouvert par un troisième filtre 4c. Le troisième filtre 4c est configuré pour laisser passer la deuxième gamme de longueur d'onde et bloquer la première gamme de longueur d'onde. Le troisième filtre 4c peut être un filtre interférentiel ou un filtre à absorption.

Le troisième filtre 4c peut être un filtre passe-bas ou un filtre passe-haut dont la longueur d'onde de coupure se trouve entre la première gamme de longueur d'onde et la deuxième gamme de longueur d'onde. Si le premier filtre est un filtre passe-bas, le deuxième filtre est un filtre passe-haut et inversement.

En alternative, il est également possible de prévoir que le troisième filtre 4c est un filtre passe-bande qui laisse passer la deuxième gamme de longueur d'onde et qui bloque la première gamme de longueur d'onde. Ce mode de réalisation est moins avantageux que le précédent car un filtre passe-bande est plus épais qu'un filtre passe-bas ou passe-haut.

Le troisième filtre 4c est un filtre déposé directement sur le deuxième photodétecteur 1b, c'est-à-dire sur une partie du réseau plan focal. Le troisième filtre 4c n'est pas déposé sur le premier photodétecteur 1a ainsi le troisième filtre 4c vient recouvrir uniquement le deuxième photodétecteur 1b et il laisse découvert le premier photodétecteur 1a. Le troisième filtre 4c est en contact physique avec le deuxième photodétecteur. Le troisième filtre 4c permet de limiter la diaphonie (ou Crosstalk en langue anglaise) entre le premier photodétecteur 1a et le deuxième photodétecteur 1b adjacent.

Au moyen de cette configuration particulière, le deuxième photodétecteur 1b ne reçoit qu'une partie du rayonnement incident. Le deuxième photodétecteur 1b reçoit la deuxième gamme de longueur d'onde et il ne reçoit pas la première gamme de longueur d'onde. Chaque photodétecteur fournit une information représentative de la gamme de longueur d'onde observée. Le circuit de traitement peut être simplifié car il n'est plus nécessaire de comparer les signaux en provenance des deux photodétecteurs.

Dans les différents exemples illustrés aux figures 3a, 4a, 5a, 6a, 7a, 8a et 9a, la courbe d'émission de la scène observée s'étend au-delà des premières et deuxième gammes de longueur d'onde.

Le dispositif de détection peut être réalisé simplement de la manière suivante. Le premier photodétecteur 1a et le deuxième photodétecteur 1b sont formés sur un substrat semi-conducteur. Comme les deux photodétecteurs 1a et 1b sont sensibles aux mêmes gammes de longueur d'onde, il est avantageux de réaliser les deux photodétecteurs simultanément et avec les mêmes matériaux semi-conducteurs. Dans un mode de réalisation préférentiel, les photodétecteurs 1a et 1b sont identiques.

Les deux photodétecteurs sont décalés selon un axe parallèle au plan de la surface du substrat et ils sont dans un même plan qui est parallèle au plan de la surface de substrat.

Un premier filtre 4a est formé sur le premier photodétecteur 1a de manière à recouvrir le premier photodétecteur 1a et à laisser découvert le deuxième photodétecteur 1b.

Dans une première variante de réalisation, le premier filtre 4a est formé sur le premier photodétecteur 1a et sur le deuxième photodétecteur 1b. Le premier filtre 4a est ensuite éliminé au-dessus du deuxième photodétecteur 1b.

Dans une deuxième variante de réalisation, le deuxième photodétecteur 1b est protégé par une couche sacrificielle. Le premier filtre 4a est formé sur le premier photodétecteur 1a et sur la couche sacrificielle. La couche sacrificielle est éliminée de manière à libérer le deuxième photodétecteur 1b qui est dépourvu de premier filtre.

Ensuite, le deuxième filtre 4b est associé, par exemple mis en contact, avec le substrat contenant le premier photodétecteur 1a et le deuxième photodétecteur 1b. Le deuxième filtre 4b n'est pas formé par dépôt sur le substrat, il a été formé indépendamment et il est rapporté par la suite.

Dans la variante de réalisation, utilisant le troisième filtre 4c, le premier filtre 4a peut être formé avant ou après le troisième filtre 4c. Il est également possible de prévoir que le premier filtre 4a et le troisième filtre 4c sont formés en partie simultanément en partageant quelques couches. De manière avantageuse, le troisième filtre 4c est réalisé avant d'installer le deuxième filtre 4b. le troisième filtre 4c est disposé à distance du deuxième filtre 4b.

À titre d'exemple, il est avantageux de placer les premier et deuxième photodétecteurs 1a et 1b dans une enceinte fermée qui est avantageusement étanche. Cette enceinte fermée comporte un orifice configuré pour laisser passer le rayonnement depuis la source de rayonnement vers les premier et deuxième photodétecteurs 1a et 1b. Il est particulièrement avantageux de placer le deuxième filtre 4b dans cet orifice de manière à laisser passer les première et deuxième gammes de longueur d'onde et à bloquer une partie du rayonnement inutile. L'orifice est avantageusement une fenêtre 6 en matériau transparent recouvert par le deuxième filtre 4b. Le deuxième filtre 4b peut être situé à l'intérieur de l'enceinte fermée (figure 1) ou à l'extérieur de l'enceinte fermée (figure 2). Toute la surface de la fenêtre est avantageusement recouverte par le deuxième filtre 4b afin de ne laisser que le signal utile dans toutes les zones de la fenêtre.

De manière avantageuse, le dispositif de détection est un dispositif de détection refroidi, c'est-à-dire un dispositif qui est configuré pour fonctionner à une température inférieure à 300K, de préférence comprise entre 40K et 300K et de préférence inférieure à 200K. Le dispositif de détection peut également être non refroidi.

Le dispositif de détection est avantageusement couplé à un système de refroidissement 7 qui permet de le refroidir à sa température de fonctionnement.

Les photodétecteurs du dispositif de détection peuvent être réalisés en matériau II-VI, par exemple HgCdTe ou en matériau III-V, par exemple InGaAs, InSb, InAsSb.

Les photodétecteurs 1a et 1b sont avantageusement entourés par un écran froid 8 qui est configuré pour bloquer le rayonnement incident à l'exception de la fenêtre 6 de passage du rayonnement incident. Il apparaît particulièrement avantageux de placer le deuxième filtre 4b sur cette fenêtre 6 de passage du rayonnement incident.

Les zones recouvertes par le premier filtre 4a et les zones laissées découvertes par le premier filtre 4a définissent avantageusement une alternance entre les premiers photodétecteurs 1a et les deuxièmes photodétecteurs 1b.

Cette alternance entre les premier et deuxième photodétecteurs peut se traduire par la réalisation d'un damier ou d'une alternance de bandes représentées par des rangés ou des colonnes de photodétecteurs.

Dans un mode de réalisation préférentielle, la pression à l'intérieur de l'écran froid 8 est inférieure ou égale à la pression à l'extérieur de l'écran froid 8. Il est avantageux de prévoir que la pression à l'intérieur de l'écran froid 8 est inférieure à la pression atmosphérique, par exemple inférieure à 1013hPa.

Dans un mode de réalisation particulier, la pression à l'intérieur de l'écran froid est inférieure à 10⁻⁴Pa.

## Revendications

1. Dispositif de détection multispectrale comportant:
- un premier photodétecteur (1a) et un deuxième photodétecteur (1b) sensibles chacun à une première gamme de longueur d'onde et à une deuxième gamme de longueur d'onde différente de la première gamme de longueur d'onde, le premier photodétecteur (1a) délivrant un premier signal représentatif du rayonnement reçu et le deuxième photodétecteur (1b) délivrant un deuxième signal représentatif du rayonnement reçu,
- un premier filtre (4a) configuré pour laisser passer la première gamme de longueur d'onde et pour bloquer la deuxième gamme de longueur d'onde, le premier filtre (4a) recouvrant le premier photodétecteur (1a) et laissant découvert le deuxième photodétecteur (1b), le premier filtre (4a) étant disposé sur le premier photodétecteur (1a) de manière à bloquer le passage de la deuxième gamme de longueur d'onde dans le premier photodétecteur (1a) et générer des contraintes thermomécaniques dans le premier photodétecteur (1a) et dans le deuxième photodétecteur (1b),
- un deuxième filtre (4b) disposé à distance du premier et du deuxième photodétecteurs (1a, 1b) et à distance du premier filtre (4a), le deuxième filtre (4b) étant configuré pour laisser passer la première gamme de longueur d'onde et la deuxième gamme de longueur d'onde, le deuxième filtre (4b) étant configuré pour bloquer une longueur d'onde supérieure à la plus longue des longueurs d'onde parmi les première et deuxième gammes de longueur d'onde et/ou pour bloquer une longueur d'onde inférieure à la plus courte des longueurs d'onde parmi les première et deuxième gammes de longueur d'onde, le premier filtre (4a) et le deuxième filtre (4b) étant disposés successivement dans le chemin optique du premier photodétecteur (1a), le deuxième filtre (4b) étant commun au premier photodétecteur (1a) et au deuxième photodétecteur (1b),
le dispositif de détection multispectrale étant **caractérisé en ce que** les première et deuxième gammes de longueur d'onde sont des gammes du rayonnement infrarouge et **en ce qu'**il comporte :
- une couche de passivation continue qui recouvre les premier et deuxième photodétecteurs (1a, 1b) de manière monolithique et qui est disposée entre le premier photodétecteur (1a) et le premier filtre (4a), la couche de passivation présentant une épaisseur comprise entre 10nm et 2000nm pour lisser les contraintes thermomécaniques sur les premier et deuxième photodétecteurs (1a, 1b).

2. Dispositif de détection selon la revendication 1 dans lequel le deuxième photodétecteur (1b) est dépourvu de filtre configuré pour bloquer la première gamme de longueur d'onde de manière à recevoir la première gamme de longueur d'onde et la deuxième gamme de longueur d'onde, le dispositif de détection comportant un circuit de traitement (5) configuré pour recevoir des signaux électriques en provenance des premier et deuxième photodétecteurs (1a, 1b) et fournir une information relative au rayonnement de la deuxième gamme de longueur d'onde par comparaison du premier signal avec le deuxième signal.

3. Dispositif de détection selon la revendication 1 dans lequel le deuxième photodétecteur (1b) est recouvert par un troisième filtre (4c) configuré pour bloquer la première gamme de longueur d'onde et laisser passer la deuxième gamme de longueur d'onde.

4. Dispositif de détection selon l'une quelconque des revendications précédentes **caractérisé en ce que** le deuxième filtre (4b) est choisi parmi les filtres passe-bas, passe-haut, passe-bande et bi-bande.

5. Dispositif de détection selon l'une quelconque des revendications précédentes **caractérisé en ce que** le premier filtre (4a) est un filtre passe-bas, passe-haut ou passe-bande coupant la deuxième gamme de longueur d'onde.

6. Dispositif de détection selon l'une quelconque des revendications précédentes **caractérisé en ce que** le deuxième filtre (4b) est disposé à distance du premier filtre (4a) et du deuxième photodétecteur (1b) par une couche de gaz ou du vide.

7. Dispositif de détection selon l'une quelconque des revendications précédentes **caractérisé en ce qu'**il comporte un écran froid (8) configuré pour focaliser le rayonnement incident au moyen d'un orifice de passage du rayonnement et **en ce que** le deuxième filtre (4b) est disposé dans ledit orifice.

8. Dispositif de détection selon la revendication 7 **caractérisé en ce que** l'écran froid (8) définit une enceinte fermée contenant les premier et deuxième photodétecteurs (1a, 1b) et **en ce que** le deuxième filtre (4b) est disposé dans l'enceinte fermée.

9. Dispositif de détection selon la revendication 7 **caractérisé en ce que** l'écran froid (8) définit une enceinte fermée contenant les premier et deuxième photodétecteurs (1a, 1b) et **en ce que** le deuxième filtre (4b) est disposé hors de l'enceinte fermée.

10. Procédé de fabrication d'un dispositif de détection multispectrale comportant les étapes suivantes :
- prévoir un substrat comportant des premier et deuxième photodétecteurs (1a et 1b) et une couche de passivation continue qui recouvre les premier et deuxième photodétecteurs (1a, 1b) de manière monolithique, la couche de passivation présentant une épaisseur comprise entre 10nm et 2000nm, les premier et deuxième photodétecteurs (1a, 1b) étant sensibles chacun à une première gamme de longueur d'onde et à une deuxième gamme de longueur d'onde différente de la première gamme de longueur d'onde, le premier photodétecteur (1a) délivrant un premier signal représentatif du rayonnement reçu et le deuxième photodétecteur (1b) délivrant un deuxième signal représentatif du rayonnement reçu, les première et deuxième gammes de longueur d'onde étant des gammes du rayonnement infrarouge,
- former un premier filtre (4a) configuré pour laisser passer la première gamme de longueur d'onde et pour bloquer la deuxième gamme de longueur d'onde, le premier filtre (4a) recouvrant le premier photodétecteur (1a) et laissant découvert le deuxième photodétecteur (1b), le premier filtre (4a) étant disposé sur la couche de passivation et le premier photodétecteur (1a) de manière à bloquer le passage de la deuxième gamme de longueur d'onde dans le premier photodétecteur (1a), le premier filtre (4a) étant séparé du premier photodétecteur (1a) par la couche de passivation, le premier filtre (4a) générant des contraintes thermomécaniques dans le premier photodétecteur (1a) et dans le deuxième photodétecteur (1b),
- former un deuxième filtre (4b) disposé à distance du premier et du deuxième photodétecteurs (1a, 1b) et à distance du premier filtre (4a), le deuxième filtre (4b) étant configuré pour laisser passer la première gamme de longueur d'onde et la deuxième gamme de longueur d'onde, le deuxième filtre (4b) étant configuré pour bloquer une longueur d'onde supérieure à la plus longue des longueurs d'onde parmi les première et deuxième gammes de longueur d'onde et/ou pour bloquer une longueur d'onde inférieure à la plus courte des longueur d'onde parmi les première et deuxième gammes de longueur d'onde, le premier filtre (4a) et le deuxième filtre (4b) étant disposés successivement dans le chemin optique du premier photodétecteur (1a), le deuxième filtre (4b) étant commun au premier photodétecteur (1a) et au deuxième photodétecteur (1b), la couche de passivation lissant les contraintes thermomécaniques sur les premier et deuxième photodétecteurs (1a, 1b).

11. Procédé de fabrication selon la revendication 10 comportant, avant de former le deuxième filtre (4b) :
- former un troisième filtre (4c) configuré pour laisser passer la deuxième gamme de longueur d'onde et pour bloquer la première gamme de longueur d'onde, le troisième filtre (4c) recouvrant le deuxième photodétecteur (1b) et laissant découvert le premier photodétecteur (1a), le troisième filtre (4c) étant en contact avec le deuxième photodétecteur (1b) de manière à bloquer le passage de la première gamme de longueur d'onde dans le deuxième photodétecteur (1b).

## Patentansprüche

1. Multispektrale Detektionsvorrichtung, umfassend:
- einen ersten Fotodetektor (1a) und einen zweiten Fotodetektor (1b), die jeweils gegenüber einem ersten Wellenlängenbereich und einem zweiten Wellenlängenbereich, der sich vom ersten Wellenlängenbereich unterscheidet, empfindlich sind, wobei der erste Fotodetektor (1a) ein erstes Signal ausgibt, das für die empfangene Strahlung repräsentativ ist, und der zweite Fotodetektor (1b) ein zweites Signal ausgibt, das für die empfangene Strahlung repräsentativ ist,
- einen ersten Filter (4a), der dazu konfiguriert ist, den ersten Wellenlängenbereich durchzulassen und den zweiten Wellenlängenbereich zu blockieren, wobei der erste Filter (4a) den ersten Fotodetektor (1a) bedeckt und den zweiten Fotodetektor (1b) unbedeckt lässt, der erste Filter (4a) derart auf dem ersten Fotodetektor (1a) angeordnet ist, dass der Durchgang des zweiten Wellenlängenbereichs in den ersten Fotodetektor (1a) blockiert wird und im ersten Fotodetektor (1a) und im zweiten Fotodetektor (1b) thermomechanische Beanspruchungen erzeugt werden,
- einen zweiten Filter (4b), der beabstandet vom ersten und vom zweiten Fotodetektor (1a, 1b) und beabstandet vom ersten Filter (4a) angeordnet ist, wobei der zweite Filter (4b) dazu konfiguriert ist, den ersten Wellenlängenbereich und den zweiten Wellenlängenbereich durchzulassen, der zweite Filter (4b) dazu konfiguriert ist, eine Wellenlänge zu blockieren, die größer ist als die längste der Wellenlängen des ersten und zweiten Wellenlängenbereichs, und/oder eine Wellenlänge zu blockieren, die kleiner ist als die kürzeste der Wellenlängen des ersten und zweiten Wellenlängenbereichs, wobei der erste Filter (4a) und der zweite Filter (4b) im Lichtweg des ersten Fotodetektors (1a) aufeinanderfolgend angeordnet sind, wobei der zweite Filter (4b) dem ersten Fotodetektor (1a) und dem zweiten Fotodetektor (1b) gemeinsam ist,
wobei die multispektrale Detektionsvorrichtung **dadurch gekennzeichnet ist, dass** der erste und der zweite Wellenlängenbereich Bereiche der Infrarotstrahlung sind, und dass sie umfasst:
- eine durchgehende Passivierungsschicht, die den ersten und den zweiten Fotodetektor (1a, 1b) monolithisch bedeckt und zwischen dem ersten Fotodetektor (1a) und dem ersten Filter (4a) angeordnet ist, wobei die Passivierungsschicht eine Dicke zwischen 10 nm und 2000 nm aufweist, um die thermomechanischen Beanspruchungen auf dem ersten und dem zweiten Fotodetektor (1a, 1b) zu glätten.

2. Detektionsvorrichtung nach Anspruch 1, wobei der zweite Fotodetektor (1b) mit keinem Filter versehen ist, der dazu konfiguriert ist, den ersten Wellenlängenbereich zu blockieren, sodass er den ersten Wellenlängenbereich und den zweiten Wellenlängenbereich empfängt, wobei die Detektionsvorrichtung eine Verarbeitungsschaltung (5) umfasst, die dazu konfiguriert ist, vom ersten und vom zweiten Fotodetektor (1a, 1b) elektrische Signale zu empfangen und durch Vergleichen des ersten Signals mit dem zweiten Signal eine Information bezüglich der Strahlung des zweiten Wellenlängenbereichs bereitzustellen.

3. Detektionsvorrichtung nach Anspruch 1, wobei der zweite Fotodetektor (1b) von einem dritten Filter (4c) bedeckt ist, der dazu konfiguriert ist, den ersten Wellenlängenbereich zu blockieren und den zweiten Wellenlängenbereich durchzulassen.

4. Detektionsvorrichtung nach einem der vorherigen Ansprüche, **dadurch gekennzeichnet, dass** der zweite Filter (4b) aus einem Tiefpass-, Hochpass-, Bandpass- und Dualbandfilter gewählt ist.

5. Detektionsvorrichtung nach einem der vorherigen Ansprüche, **dadurch gekennzeichnet, dass** der erste Filter (4a) ein Tiefpass-, Hochpass- oder Bandpassfilter ist, der den zweiten Wellenlängenbereich abschneidet.

6. Detektorvorrichtung nach einem der vorherigen Ansprüche, **dadurch gekennzeichnet, dass** der zweite Filter (4b) durch eine Gasschicht oder ein Vakuum vom ersten Filter (4a) und vom zweiten Photodetektor (1b) beabstandet angeordnet ist.

7. Detektionsvorrichtung nach einem der vorherigen Ansprüche, **dadurch gekennzeichnet, dass** sie einen Kälteschirm (8) umfasst, der dazu konfiguriert ist, die einfallende Strahlung durch eine Durchgangsöffnung für die Strahlung zu fokussieren, und dass der zweite Filter (4b) in dieser Öffnung angeordnet ist.

8. Detektionsvorrichtung nach Anspruch 7, **dadurch gekennzeichnet, dass** der Kälteschirm (8) ein geschlossenes Gehäuse definiert, das den ersten und den zweiten Fotodetektor (1a, 1b) enthält, und dass der zweite Filter (4b) im geschlossenen Raum angeordnet ist.

9. Detektionsvorrichtung nach Anspruch 7, **dadurch gekennzeichnet, dass** der Kälteschirm (8) ein geschlossenes Gehäuse definiert, das den ersten und den zweiten Fotodetektor (1a, 1b) enthält, und dass der zweite Filter (4b) außerhalb des geschlossenen Gehäuses angeordnet ist.

10. Verfahren zur Herstellung einer multispektralen Detektionsvorrichtung, umfassend:
- Bereitstellen eines Substrats, das einen ersten und einen zweiten Fotodetektor (1a und 1b) und eine durchgehende Passivierungsschicht umfasst, die den ersten und den zweiten Fotodetektor (1a, 1b) monolithisch bedeckt, wobei die Passivierungsschicht eine Dicke zwischen 10 nm und 2000 nm aufweist, wobei der erste und der zweite Fotodetektor (1a, 1b) jeweils gegenüber einem ersten Wellenlängenbereich und einen zweiten Wellenlängenbereich, der sich vom ersten Wellenlängenbereich unterscheidet, empfindlich sind, wobei der erste Fotodetektor (1a) ein erstes Signal ausgibt, das für die empfangene Strahlung repräsentativ ist, und der zweite Fotodetektor (1b) ein zweites Signal ausgibt, das für die empfangene Strahlung repräsentativ ist, wobei der erste und der zweite Wellenlängenbereich Bereiche der Infrarotstrahlung sind,
- Bilden eines ersten Filters (4a), der dazu konfiguriert ist, den ersten Wellenlängenbereich durchzulassen und den zweiten Wellenlängenbereich zu blockieren, wobei der erste Filter (4a) den ersten Fotodetektor (1a) bedeckt und den zweiten Fotodetektor (1b) unbedeckt lässt, der erste Filter (4a) derart auf dem ersten Fotodetektor (1a) angeordnet ist, dass er den Durchgang des zweiten Wellenlängenbereichs in den ersten Fotodetektor (1a) blockiert, der erste Filter (4a) durch die Passivierungsschicht vom ersten Fotodetektor (1a) getrennt ist, der erste Filter (4a) im ersten Fotodetektor (1a) und im zweiten Fotodetektor (1b) thermomechanische Beanspruchungen erzeugt,
- Bilden eines zweiten Filters (4b), der beabstandet vom ersten und vom zweiten Fotodetektor (1a, 1b) und beabstandet vom ersten Filter (4a) angeordnet ist, wobei der zweite Filter (4b) dazu konfiguriert ist, den ersten Wellenlängenbereich und den zweiten Wellenlängenbereich durchzulassen, der zweite Filter (4b) dazu konfiguriert ist, eine Wellenlänge zu blockieren, die größer ist als die längste der Wellenlängen des ersten und zweiten Wellenlängenbereichs, und/oder eine Wellenlänge zu blockieren, die kleiner ist als die kürzeste der Wellenlängen des ersten und zweiten Wellenlängenbereichs, wobei der erste Filter (4a) und der zweite Filter (4b) im Lichtweg des ersten Fotodetektors (1a) aufeinanderfolgend angeordnet sind, der zweite Filter (4b) dem ersten Fotodetektor (1a) und dem zweiten Fotodetektor (1b) gemeinsam ist, wobei die Passivierungsschicht die thermomechanischen Beanspruchungen auf dem ersten und dem zweiten Fotodetektor (1a, 1b) glättet.

11. Herstellungsverfahren nach Anspruch 10, umfassend, vor dem Bilden des zweiten Filters (4b):
- Bilden eines dritten Filters (4c), der dazu konfiguriert ist, den zweiten Wellenlängenbereich durchzulassen und den ersten Wellenlängenbereich zu blockieren, wobei der dritte Filter (4c) den zweiten Fotodetektor (1b) bedeckt und den ersten Fotodetektor (1a) unbedeckt lässt, wobei der dritte Filter (4c) derart mit dem zweiten Fotodetektor (1b) in Kontakt ist, dass er den Durchgang des ersten Wellenlängenbereichs in den zweiten Fotodetektor (1b) blockiert.

## Claims

1. Multispectral detection device comprising:
- a first photodetector (1a) and a second photodetector (1b) each sensitive to a first wavelength range and to a second wavelength range different from the first wavelength range, the first photodetector (1a) delivering a first signal representative of the received radiation and the second photodetector (1b) delivering a second signal representative of the received radiation,
- a first filter (4a) configured for to allow the first wavelength range to pass and to block the second wavelength range, the first filter (4a) covering the first photodetector (1a) and leaving the second photodetector (1b) uncovered, the first filter (4a) being arranged on the first photodetector (1a) so as to block the passage of the second wavelength range in the first photodetector (1a) and generate thermomechanical stresses in the first photodetector (1a) and in the second photodetector (1b),
- a second filter (4b) arranged at a distance from the first and second photodetectors (1a, 1b) and at a distance from the first filter (4a), the second filter (4b) being configured to allow the first wavelength range and the second wavelength range to pass, the second filter (4b) being configured to block a higher wavelength than the longest of the wavelengths in the first and second wavelength ranges and/or to block a lower wavelength than the shortest of the wavelengths in the first and second wavelength ranges, the first filter (4a) and the second filter (4b) being arranged successively in the optical path of the first photodetector (1a), the second filter (4b) being common to the first photodetector (1a) and the second photodetector (1b),
the multispectral detection device being **characterized in that** the first and second wavelength ranges are infrared radiation ranges and **in that** it comprises:
- a continuous passivation layer which monolithically covers the first and second photodetectors (1a, 1b) and is arranged between the first photodetector (1a) and the first filter (4a), the passivation layer having a thickness of between 10nm and 2000nm to smooth thermomechanical stresses on the first and second photodetectors (1a, 1b).

2. Detection device according to claim 1 wherein the second photodetector (1b) is devoid of a filter configured to block the first wavelength range so as to receive the first wavelength range and the second wavelength range, the detection device comprising a processing circuit (5) configured to receive electric signals coming from the first and second photodetectors (1a, 1b) and to provide data relative to the radiation of the second wavelength range by comparing the first signal with the second signal.

3. Detection device according to claim 1 wherein the second photodetector (1b) is covered by a third filter (4c) configured to block the first wavelength range and to allow the second wavelength range to pass.

4. Detection device according to any one of the foregoing claims **characterised in that** the second filter (4b) is chosen from low-pass, high-pass, bandpass and dual-band filters.

5. Detection device according to any one of the foregoing claims **characterised in that** the first filter (4a) is a low-pass, high-pass or bandpass filter cutting off the second wavelength range.

6. Detection device according to any one of the foregoing claims **characterised in that** the second filter (4b) is arranged at a distance from the first filter (4a) and the second photodetector (1b) separated by a layer of gas or a void.

7. Detection device according to any one of the foregoing claims **characterised in that** it comprises a cold shield (8) configured to focus the incident radiation by means of an aperture for passage of the radiation and **in that** the second filter (4b) is arranged in said aperture.

8. Detection device according to claim 7 **characterised in that** the cold shield (8) defines a closed enclosure containing the first and second photodetectors (1a, 1b) and **in that** the second filter (4b) is located in the closed enclosure.

9. Detection device according to claim 7 **characterised in that** the cold shield (8) defines a closed enclosure containing the first and second photodetectors (1a, 1b) and **in that** the second filter (4b) is located outside the closed enclosure.

10. Fabrication method of a multispectral detection device **characterised in that** it comprises the following steps:
- providing a substrate comprising first and second photodetectors (1a and 1b) and a continuous passivation layer monolithically covering the first and second photodetectors (1a, 1b), the passivation layer having a thickness of between 10nm and 2000nm, the first and second photodetectors (1a, 1b) each being sensitive to a first wavelength range and to a second wavelength range different from the first wavelength range, the first photodetector (1a) delivering a first signal representative of the received radiation and the second photodetector (1b) delivering a second signal representative of the received radiation, the first and second wavelength ranges being ranges of the infrared radiation,
- forming a first filter (4a) configured to allow the first wavelength range to pass and to block the second wavelength range, the first filter (4a) covering the first photodetector (1a) and leaving the second photodetector (1b) uncovered, the first filter (4a) being arranged on the passivation layer and the first photodetector (1a) so as to block the passage of the second wavelength range into the first photodetector (1a), the first filter (4a) being separated from the first photodetector (1a) by the passivation layer, the first filter (4a) generating thermomechanical stresses in the first photodetector (1a) and in the second photodetector (1b),
- forming a second filter (4b) arranged at a distance from the first and second photodetectors (1a, 1b) and at a distance from the first filter (4a), the second filter (4b) being configured to allow the first wavelength range and the second wavelength range to pass, the second filter (4b) being configured to block a higher wavelength than the longest of the wavelengths in the first and second wavelength ranges and/or to block a lower wavelength than the shortest of the wavelengths in the first and second wavelength ranges, the first filter (4a) and the second filter (4b) being arranged successively in the optical path of the first photodetector (1a), the second filter (4b) being common to the first photodetector (1a) and the second photodetector (1b), the passivation layer smoothing thermomechanical stresses on the first and second photodetectors (1a, 1b).

11. Fabrication method according to claim 10 comprising, before the second filter (4b) is formed:
- forming a third filter (4c) configured to allow the second wavelength range to pass and to block the first wavelength range, the third filter (4c) covering the second photodetector (1b) and leaving the first photodetector (1a) uncovered, the third filter (4c) being in contact with the second photodetector (1b) so as to block the passage of the first wavelength range in the second photodetector (1b).
